(19) Europäisches Patentamt

European Patent Office

Office européen des brevets

(11) **EP 0 818 078 B1**

(12) **EUROPÄISCHE PATENTSCHRIFT**

(45) Veröffentlichungstag und Bekanntmachung des Hinweises auf die Patenterteilung:
**01.08.2001   Patentblatt 2001/31**

(21) Anmeldenummer: **96905745.4**

(22) Anmeldetag: **19.03.1996**

(51) Int Cl.$^7$: **H03H 17/02**, H03H 17/04

(86) Internationale Anmeldenummer:
**PCT/DE96/00475**

(87) Internationale Veröffentlichungsnummer:
**WO 96/31001 (03.10.1996 Gazette 1996/44)**

(54) **DIGITALES FILTER**

DIGITAL FILTER

FILTRE NUMERIQUE

(84) Benannte Vertragsstaaten:
**DE FR SE**

(30) Priorität: **27.03.1995  DE 19511148**

(43) Veröffentlichungstag der Anmeldung:
**14.01.1998   Patentblatt 1998/03**

(73) Patentinhaber: **Blaupunkt-Werke GmbH**
**31132 Hildesheim (DE)**

(72) Erfinder: **HERRMANN, Matthias**
**D-31141 Hildesheim (DE)**

(56) Entgegenhaltungen:
**DE-A- 3 034 584          US-A- 3 967 102**

EP 0 818 078 B1

## Beschreibung

Die Erfindung betrifft ein digitales Filter nach der Gattung des Hauptanspruchs.

Beim mobilen Empfang von frequenzmodulierten Hörfunksendungen hat es sich als günstig erwiesen, bei geringen Empfangsfeldstärken eine afaptive Höhenabsenkung im NF-Bereich durchzuführen. Dieses kann an sich über bekannte Klangsteller erfolgen. Außerdem sind Filter bekannt, die eine Unterdrückung des Pilotsignals von 19 kHz beim UKW-Empfang ermöglichen.

Aus der DE-A-30 34 584 ist ein Verfahren zur Konstruktion eines digitalen Filters mit einem rekursiven Anteil und einem nichtrekursiven Anteil, das eine Bandpaß- oder Bandsperrcharakteristik aufweist, beschrieben. Dabei ist mindestens einer der Parameter Mittenfrequenz, Gütefaktor oder Verstärkung der Kennlinie variabel, wobei zur Berechnung eines Filters mit veränderlicher Filterkennlinie und Gütefaktor als Parameter eine konkrete Berechnungsvorschrift angegeben wird.

Weiterhin ist aus der US-A-3 967 102 eine digitale Filteranordnung bestehend aus zwei baugleichen hintereinander geschalteten rekursiven Filtern bekannt, wobei die Ausgangssignalleistung des zweiten Filters auf einen vorgegebenen Wert eingeregelt wird. Dazu wird das Ausgangssignal des zweiten Filters mit dessen Eingangssignal verglichen und in Abhängigkeit des Vergleichssignals die Koeffizienten der beiden Filter eingestellt.

Das erfindungsgemäße Filter mit den Merkmalen des Hauptanspruchs hat den Vorteil, daß nunmehr bei über Rundfunk ausgestrahlten Hörfunksendungen eine automatische Höhenabsenkung beim wiederzugebenden Audiosignal mit einem Minimum an Aufwand möglich wird. Die Ableitung des Steuerparameters aus einem von der Empfangsfeldstärke in einem Rundfunkempfänger abhängigen Signal durch Normierung und Tiefpaßfilterung ermöglicht eine Steuerung des Filters zwischen vorgegebenen Grenzen. Zur Unterdrückung des Pilotsignals beim Verkehrsfunk ist das erfindungsgemäße Filter derart ausgebildet, daß die Nullstelle bei 19 kHz liegt.

Das erfindungsgemäße Filter ist vorzugsweise für eine adaptive Höhenabsenkung und eine Unterdrükkung des Pilotsignals durch eine entsprechend gewählte Nullstelle geeignet. Es sind jedoch auch andere Anwendungen des erfindungsgemäßen digitalen Filters möglich.

Digitale Filter mit einem rekursiven und einem nichtrekursiven Anteil sind beispielsweise beschrieben in Schönfelder, Helmut (Hrsg.): "Digitale Filter in der Videotechnik", Berlin 1988, Seiten 80 bis 82.

Vorzugsweise ist bei dem erfindungsgemäßen digitalen Filter vorgesehen, daß die Koeffizienten aus einem Steuerparameter berechnet werden. Dadurch ist ein zweckmäßiger Zusammenhang zwischen einem Steuerparameter und der Filtercharakteristik herstellbar. Ein linearer Zusammenhang ergibt sich vorzugsweise dadurch, daß der nichtrekursive Anteil Koeffizienten A0, A1 und A2 und der rekursive Anteil Koeffizienten B1 und B2 aufweist, die aus dem zugeführten Steuerparameter s wie folgt berechnet werden:

$$A0 = A2 = V0 \cdot [(1 + \alpha \cdot s + \beta + \delta \cdot s^2)/(2 - 2\cos phi_0)],$$

$$A1 = -2 \cdot A0 \cdot \cos phi_0,$$

$$B1 = \alpha \cdot s + \beta,$$

$$B2 = \delta \cdot s^2,$$

wobei V0 der Übertragungsfaktor bei der Frequenz 0 ist und c, β, und δ Konstanten sind und wobei ferner $phi_0 = 2\pi \cdot f_0/f_s$ gilt mit $f_0$ als Frequenz der Nullstelle und $f_s$ als Abtastfrequenz.

Eine Wahl der Konstanten zur Anpassung des erfindungsgemäßen Filters an verschiedene Anwendungsfälle ist dem Fachmann möglich. Vorzugsweise ist bei dem erfindungsgemäßen Filter vorgesehen, daß $\alpha$ = 2, β = -0,356, δ = 0,90252 und $phi_0$ = 2,62 ist.

Ausführungsbeispiele der Erfindung sind in der Zeichnung anhand mehrerer Figuren dargestellt und in der nachfolgenden Beschreibung näher erläutert. Es zeigt:

Fig. 1 ein Blockschaltbild eines erfindungsgemäßen Filters,

Fig. 2 ein bei dem Filter nach Fig. 1 in vorteilhafter Weise verwendbares rekursives Filter und

Fig. 3 Filterkurven eines Ausführungsbeispiels für verschiedene Werte des Steuerparameters s.

Gleiche Teile sind in den Figuren mit gleichen Eezugszeichen versehen. Das Ausführungsbeispiel sowie Teile davon sind zwar als Blockschaltbilder dargestellt. Dieses bedeutet jedoch nicht, daß das erfindungsgemäße Filter auf eine Realisierung mit Hilfe von einzelnen den Blöcken entsprechenden Schaltungen beschränkt ist. Das erfindungsgemäße Filter ist vielmehr in besonders vorteilhafter Weise mit Hilfe von hochintegrierten Schaltungen realisierbar. Dabei können digitale Signalprozessoren eingesetzt werden, welche bei geeigneter Programmierung die in den Blockschaltbildern dargestellten Verarbeitungsschritte durchführen. Das erfindungsgemäße Filter kann zusammen mit weiteren Schaltungen innerhalb einer integrierten Schaltung wesentliche Teile eines Rundfunkempfängers bilden.

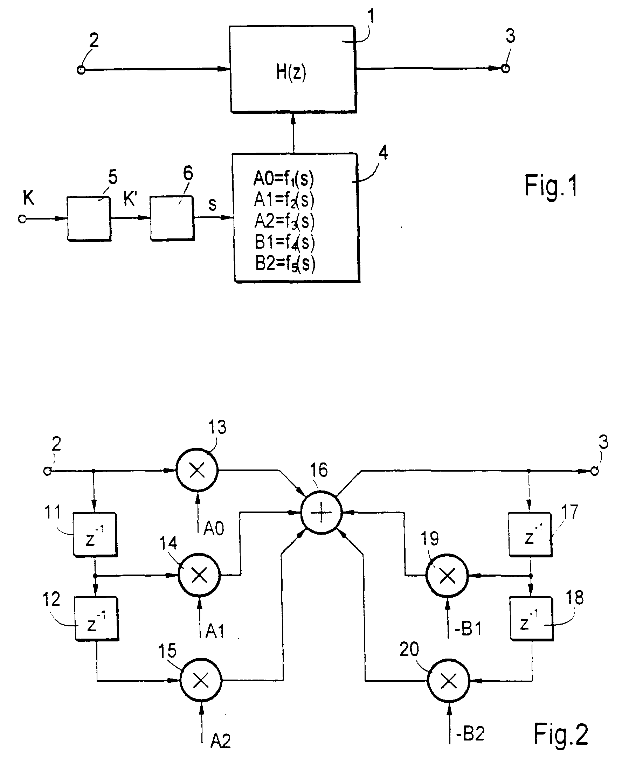

Das Ausführungsbeispiel nach Fig. 1 umfaßt ein rekursives Filter 1 zweiter Ordnung mit der Übertragungsfunktion H(z), einem Eingang 2 und einem Ausgang 3. Die Koeffizienten des rekursiven Filters 1 sind über eine Rechenschaltung 4 steuerbar, der ein Steuerparameter s zugeführt wird. Im einzelnen werden Koeffizienten A0, A1, A2, B1 und B2 als Funktion des Steuerparameters s berechnet. Der Steuerparameter s wird aus einer zugeführten Größe K durch Normierung bei 5 (K') und Tiefpaßfilterung bei 6 abgeleitet. Bei der bevorzugten Anwendung des erfindungsgemäßen Filters ist K beispielsweise ein Maß für die jeweils gemessene Empfangsfeldstärke.

Fig. 2 zeigt eine Ausführungsform des rekursiven Filters 1 (Fig. 1) mit einem rekursiven und einem nichtrekursiven Anteil. Das dem Eingang 2 zugeführte digitale Signal wird bei 11 und 12 jeweils um eine Abtastperiode verzögert. Das unverzögerte Eingangssignal sowie die um eine bzw. um zwei Abtastperioden verzögerten Eingangssignale werden über Multiplizierer 13, 14, 15 geleitet, welchen die Koeffizienten A0, A1, A2 von der Recheneinheit 4 (Fig. 1) zugeführt werden. Die Ausgangssignale der Multiplizierer 13, 14, 15 werden einem Addierer 16 zugeleitet, dessen Ausgang den Ausgang 3 des digitalen Filters darstellt. Das dort anliegende Signal wird bei 17 und 18 zweimal um eine Abtastperiode verzögert und über Multiplizierer 19, 20 dem Addierer 16 zugeleitet. Die Multiplizierer 19, 20 erhalten die Koeffizienten -B1 und -B2.

Die Verzögerer 11, 12 und die Multiplizierer 13, 14, 15 stellen den nichtrekursiven Anteil dar, während die Verzögerer 17, 18 und die Multiplizierer 19, 20 den rekursiven Anteil bilden. Wegen des meist vorherrschenden rekursiven Anteils werden derartige Filter trotz des nichtrekursiven Anteils als rekursive Filter bezeichnet.

Für die Übertragungsfunktion H(z) eines Filters zweiter Ordnung gilt:

$$H(z) = (a_0 + a_1 z^{-1} + a_2 z^{-2})/(b_0 + b_1 z^{-1} + b_2 z^{-2})$$

Für den speziellen Fall eines konjugiert komplexen Nullstellenpaares gilt:

$$a_0 = 1; \ b_0 = 1 \ ; \ a_1 = -2 \cdot \cos phi_0; \ a_2 = 1;$$

wobei $phi_0 = 2\pi \cdot f_0/f_s$ ist. Dabei ist $f_0$ die Nullstellenfrequenz und $f_s$ die Abtastfrequenz.

Für die auf eine Gleichspannungsverstärkung V0 normierten Zähler-Koeffizienten gelten mit H(z=1) = V0 folgende Gleichungen:

$$A0 = V0 \cdot (1 + b_1 + b_2)/(2 - 2\cos phi_0)$$

$$A1 = V0 \cdot [(1 + b_1 + b_2)/(2 - 2\cos phi_0)] \cdot (-2\cos phi_0)$$

$$A2 = A0$$

Um zusätzlich zu der festen Nullstelle eine kontinuierlich durchstimmbare Tiefpaßcharakteristik zu erhalten, wird angesetzt:

$$b_1 = \alpha \cdot s + \beta; \ b_2 = \delta \cdot s^2.$$

Durch Einsetzen dieser Gleichungen in die obigen Gleichungen erhält man die Abhängigkeit der Koeffizienten von dem Steuerparameter in folgender Weise:

$$A0 = A2 = V0 \cdot [(1 + \alpha \cdot s + \beta + \delta \cdot s^2)/(2 - 2\cos phi_0)],$$

$$A1 = -2 \cdot A0 \cdot \cos phi_0,$$

$$B1 = \alpha \cdot s + \beta,$$

$$B2 = \delta \cdot s^2.$$

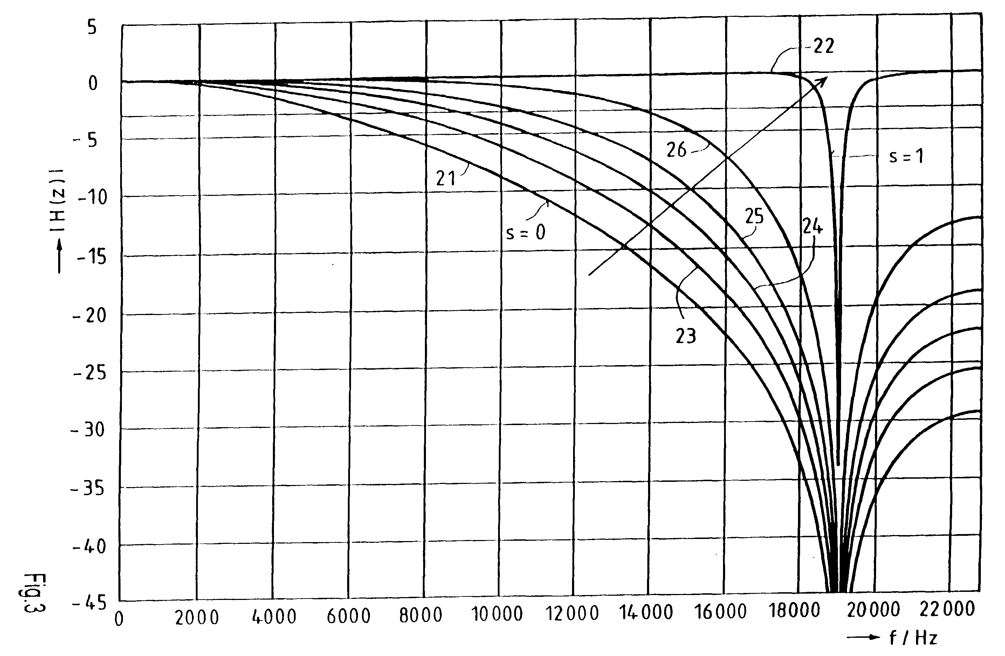

Fig. 3 zeigt den Betrag des Übertragungsfaktors H(z) in dB als Funktion der Frequenz f in Hz. Bei der Frequenz 0 ist der Betrag des Übertragungsfaktors 1 entsprechend 0 dB. Die Nullstelle befindet sich bei f = 19 kHz. Innerhalb des Frequenzbereichs zwischen 0 und 19 kHz weist das Filter eine Tiefpaßcharakteristik auf. Der Verlauf kann durch Einstellung von s = 0 bis s = 1 in Richtung des Pfeils kontinuierlich durchgestimmt werden, wobei für s = 0 die Kurve 21 und für s = 1 die Kurve 22 gilt. Für einige Zwischenwerte von s sind in Fig. 1 einige Kurven 23, 24, 25, 26 dargestellt. Mit Hilfe des Steuerparameters s kann somit das Filter von einer deutlichen Absenkung der höheren Frequenzen des Hörbereichs bis zu einem Filter, das lediglich das Pilotsignal unterdrückt und den Frequenzbereich bis 18 kHz linear überträgt, eingestellt werden.

## Patentansprüche

1. Digitales Filter mit einem rekursiven und einem nichtrekursiven Anteil zur Steuerung der Höhenwiedergabe in einem Rundfunkempfänger, wobei Koeffizienten des rekursiven ($A_0$, $A_1$, $A_2$) und des nichtrekursiven Anteils ($B_1$, $B_2$) derart steuerbar sind, daß bei einer festliegenden Nullstelle ($f_0$) und einem vorgegebenen Übertragungsfaktor ($V_0$) die weitere Filtercharakteristik steuerbar ist, wobei die Koeffizienten ($A_0$, $A_1$, ..., $B_2$) aus einem Steuerparameter (s) berechenbar sind, dadurch gekennzeichnet, daß der Übertragungsfaktor ($V_0$) bei der Frequenz 0 vorgegeben ist, daß der Steuerparameter (s) aus einer zugeführten Größe (K) durch Normierung und Tiefpaßfilterung abgeleitet wird, und daß die zugeführte Größe (K) von der Empfangsfeldstärke in einem Rundfunkempfänger abhängig ist.

2. Digitales Filter nach Anspruch 1, gekennzeichnet durch eine Tiefpaßcharakteristik.

3. Digitales Filter nach Anspruch 1 oder 2, dadurch gekennzeichnet, daß der nichtrekursive Anteil Koeffizienten A0, A1 und A2 und der rekursive Anteil Koeffizienten B1 und B2 aufweist, die aus dem zugeführten Steuerparameter s wie folgt berechnet werden:

$$A0 = A2 = V0 \cdot [(1+\alpha \cdot s+\beta+\delta \cdot s^2)/(2-2\cos phi_0)],$$

$$A1 = -2 \cdot A0 \cdot \cos phi_0,$$

$$B1 = \alpha \cdot s+\beta,$$

$$B2 = \delta \cdot s^2,$$

wobei V0 der Übertragungsfaktor bei der Frequenz 0 ist und $\alpha$, $\beta$, und $\delta$ Konstanten sind und wobei ferner $phi_0 = 2\pi \cdot f_0/f_s$ gilt mit $f_0$ als Frequenz der Nullstelle und $f_s$ als Abtastfrequenz.

4. Digitales Filter nach Anspruch 3, dadurch gekennzeichnet, daß $\alpha = 2$, $\beta = -0,356$, $\delta = 0,90252$ und $phi_0 = 2,62$ ist.

5. Digitales Filter nach einem der vorhergehenden Ansprüche, dadurch gekennzeichnet, daß die Nullstelle ($f_0$) bei 19 kHz liegt.

**Claims**

1. Digital filter having a recursive and a nonrecursive component for controlling level reproduction in a radio receiver, where coefficients of the recursive component ($A_0$, $A_1$, $A_2$) and of the nonrecursive component ($B_1$, $B_2$) can be controlled such that, with a fixed zero ($f_0$) and a prescribed transmission factor ($v_0$), the rest of the filter characteristic can be controlled, the coefficients ($A_0$, $A_1$, ..., $B_2$) being calculable from a control parameter (s), characterized in that the transmission factor ($V_0$) is prescribed at the frequency 0, in that the control parameter (s) is derived from a supplied variable (K) by normalization and low-pass filtering, and in that the supplied variable (K) is dependent on the reception field strength in a radio receiver.

2. Digital filter according to Claim 1, characterized by a low-pass characteristic.

3. Digital filter according to Claim 1 or 2, characterized in that the nonrecursive component has coefficients A0, A1 and A2 and the recursive component has coefficients B1 and B2, which are calculated from the supplied control parameter s as follows:

$$A0 = A2 = V0 \cdot [(1+\alpha \cdot s+\beta+\delta \cdot s^2)/(2-2\cos phi_0)],$$

$$A1 = -2 \cdot A0 \cdot \cos phi_0,$$

$$B1 = \alpha \cdot s+\beta,$$

$$B2 = \delta \cdot s^2,$$

where V0 is the transmission factor at the frequency 0 and $\alpha$, $\beta$ and $\delta$ are constants, and where, in addition, $phi_0 = 2\pi \cdot f_0/f_s$ with $f_0$ as the frequency at the zero and $f_s$ as the sampling frequency.

4. Digital filter according to Claim 3, characterized in that $\alpha = 2$, $\beta = -0.356$, $\delta = 0.90252$ and $phi_0 = 2.62$.

5. Digital filter according to one of the preceding claims, characterized in that the zero ($f_0$) is at 19 kHz.

**Revendications**

1. Filtre numérique à composantes récurrente et composante non-récurrente, pour commander la reproduction de niveau dans un récepteur radio, les coefficients de la composante récurrente ($A_0$, $A_1$, $A_2$) et ceux de la composante non-récurrente ($B_1$, $B_2$) se commandant pour qu'avec un point zéro fixe ($f_0$) et un coefficient de transfert prédéterminé ($V_0$), on puisse commander la caractéristique de filtre, étendue, les coefficients ($A_0$, $A_1$, ...$B_2$) se calculant à partir d'un paramètre de commande (s),
caractérisé en ce que

- le coefficient de transfert ($V_0$) est prévu pour la fréquence O,
- le paramètre de commande (s) est déduit d'une grandeur appliquée (K) par normalisation et filtrage passe-bas et,
- la grandeur appliquée (K) dépend de l'intensité du champ de réception d'un récepteur radio.

**2.** Filtre numérique selon la revendication 1, caractérisé en ce qu'il possède une caractéristique de filtre passe-bas.

**3.** Filtre numérique selon la revendication 1 ou 2, caractérisé en ce que la composante non-récurrente présente des coefficients $A_0$, $A_1$, $A_2$) et la composante récurrente, des coefficients $(B_1, B_2)$ calculés à partir du paramètre de commande (s) appliqué, comme suit :

$$A0 = A2 = VO.[(1+c.s+\beta-\delta.s^2)/(2-2\cos\varphi_0)],$$

$$A1 = -2.AO.\cos\varphi_0,$$

$$B1 = \alpha.s+\beta,$$

$$B2 = \delta.s^2,$$

VO représentant le coefficient de transfert pour la fréquence O et $\alpha$, $\beta$, $\delta$ étant des constantes, et en outre $\varphi_0 = 2\pi.f_0/f_s$, avec $f_0$ à la fréquence du point zéro et $f_s$ la fréquence de détection.

**4.** Filtre numérique selon la revendication 3, caractérisé en ce qu'on a $\alpha = 2$, $\beta = -0,356$, $\delta = 0,90252$, $\varphi_0 = 2,62$.

**5.** Filtre numérique selon l'une des revendications précédentes, caractérisé en ce que le point zéro ($f_0$) est situé à 19 kHz.

Fig.1

Fig.2

Fig.3